Europäisches Patentamt

European Patent Office

Office européen des brevets

(11) Numéro de publication: **0 244 311**
**A1**

## (12) DEMANDE DE BREVET EUROPEEN

(21) Numéro de dépôt: 87400948.3

(22) Date de dépôt: 24.04.87

(51) Int. Cl.³: **G 01 B 7/02**
**G 01 B 7/14, H 03 K 17/95**

(30) Priorité: 30.04.86 FR 8606289

(43) Date de publication de la demande:
**04.11.87 Bulletin 87/45**

(84) Etats contractants désignés:
**DE ES GB IT NL SE**

(71) Demandeur: **PETERCEM S.A.**
**61, Route de Grenoble B.P. 320**
**F-69808 Saint Priest-Cédex(FR)**

(72) Inventeur: **Macovschi, Mihail**
**133, Cours Albert Thomas**
**F-69003 Lyon(FR)**

(74) Mandataire: **Laget, Jean-Loup et al,**
**Cabinet Pierre Loyer 18, Rue de Mogador**
**F-75009 Paris(FR)**

(54) Détecteur de proximité autocontrôlé.

(57) Un capteur 20 des oscillations définit un cycle de fonctionnement du détecteur 1 avec une première période de contrôle du fonctionnement du détecteur, et une deuxième période de détermination de la position relative de la cible 1 par rapport à la limite 7 de la zone de proximité surveillée.

Fig. 1

EP 0 244 311 A1

## Détecteur de proximité autocontrôlé

L'invention concerne un détecteur de proximité autocontrôlé.

Des détecteurs de proximité permettent de détecter le franchissement d'une limite de zone de proximité par une cible, en signalant le franchissement, entre autres, par un changement de leur consommation en courant continu. Ces détecteurs comportent soit une électronique intégrée quand généralement ils détectent la cible par le phénomène des pertes par courants de Foucault, soit une électronique déportée, quand le phénomène physique utilisé pour la détection de la cible est la variation d'inductance.

Lorsqu'ils sont à électronique déportée, les détecteurs sont contrôlables ,c'est-à-dire qu'on peut vérifier à distance si la partie sensible (le capteur) est en état de bon fonctionnement. Ces détecteurs présentent cependant deux inconvénients sérieux : la distance, du capteur à l'électronique est limitée en raison de l'influence de la ligne sur la mesure, et si l'on veut faire à la fois une mesure et un test de fonctionnement, il faut prévoir une électronique très complexe.

Lorsque les détecteurs sont à électronique intégrée, on ne peut vérifier que partiellement leur fonctionnement : on peut constater la présence d'un court-circuit ou d'une coupure de circuit, mais si la consommation est normale, on ne peut savoir si le détecteur fonctionne correctement.

Un but de la présente invention est de proposer un détecteur à électronique intégrée qui soit contrôlable à distance avec certitude.

Un autre but de l'invention est de fournir un détecteur de ce type qui soit capable de transmettre simultanément à un ou plusieurs récepteurs éloignés, un signal contenant à la fois des informations de mesure relative à la position de la cible par rapport à la limite de la zone de proximité, et des informations sur son propre fonctionnement.

L'invention a pour objet un détecteur de proximité autocontrôlé , à électronique intégrée, détectant la position d'une cible par rapport à une limite de zone de proximité grâce au phénomène des pertes par courants de Foucault, comportant un circuit oscillant LC et un oscillateur, caractérisé en ce qu'un compteur des oscillations définit un cycle de fonctionnement du détecteur , avec une première période de contrôle du fonctionnement du détecteur et une deuxième période de détermination de la position de la cible .

Selon d'autres caractéristiques de l'invention,

- le détecteur comporte un circuit pour forcer le fonctionnement de l'oscillateur , un circuit pour commander l'arrêt des oscillations, un circuit monostable pour commander alternativement , l'un ou l'autre des circuits précédents , et un compteur comptant les oscillations qu'il reçoit de l'oscillateur, et commandant le circuit monostable ;

- le détecteur comporte un circuit de remise à zéro du compteur après une durée déterminée, de façon à mettre fin au cycle de fonctionnement du détecteur en l'absence d'oscillations, c'est-à-dire lorsque la cible est rapprochée ;

- dans la première période du cycle de fonctionnement du détecteur, les signaux permettant le contrôle du fonctionnement correct du détecteur sont constitués par deux impulsions de courant séparées par un créneau ;

- chacune desdites impulsions de courant , a une durée
égale à celle de l'impulsion du circuit monostable ;

- la durée dudit créneau est fonction de la fréquence
des oscillations ;

- la durée de la deuxième période du cycle de
fonctionnement du détecteur est caractéristique de la
position de la cible par rapport à la limite de la zone
de proximité ;

- lorsque la cible est éloignée,  la durée de ladite
deuxième période du cycle est définie par comptage des
oscillations;

- lorsque la cible est rapprochée, la durée de ladite
deuxième période du cycle est définie par la période du
circuit de remise à zéro.

D'autres caractéristiques de l'invention ressortent de
la description qui suit faite avec référence au dessin
annexé sur lequel on peut voir :

Figure 1 : un schéma de principe d'un détecteur
autocontrôlé selon l'invention ;

Figure 2 : un schéma symbolique d'un exemple de
réalisation d'un détecteur autocontrôlé selon
l'invention ;

Figure 3 : un schéma des signaux électriques relevés en
divers points du circuit de la figure 1.

Figure 4 : un schéma d'un premier mode de réalisation
de la liaison d'un détecteur selon l'invention avec ses
circuits d'alimentation et de réception ;

Figure 5 : un schéma d'un deuxième mode de réalisation de la liaision d'un détecteur selon l'invention avec ses circuits d'alimentation et de réception ;

Figure 6 : un schéma d'un troisième mode de réalisation de la liaison d'un détecteur selon l'invention avec ses circuits d'alimentation et de réception ;

Figure 7 : un schéma d'un quatrième mode de réalisation de la liaison d'un détecteur selon l'invention avec ses circuits d'alimentation et de réception ;

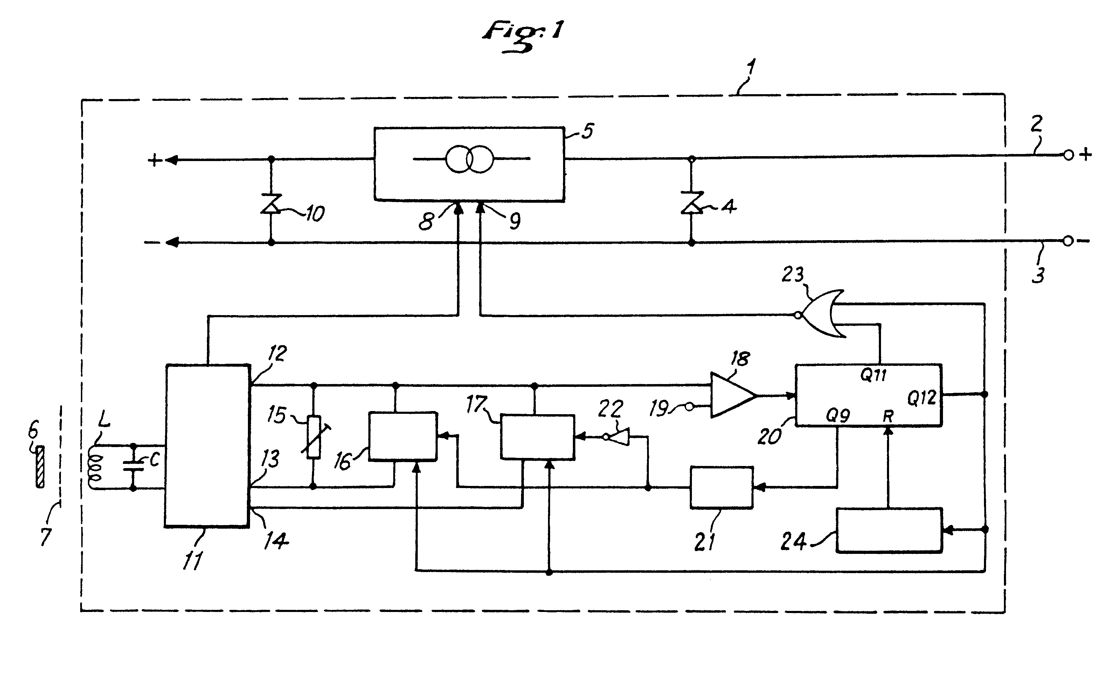

Sur la figure 1, on voit que le détecteur selon l'invention est tout entier contenu dans le cadre 1 qui est relié à un récepteur éloigné, et non représenté, par une ligne 2,3, de quelques mètres à quelques milliers de mètres, assurant également l'alimentation du capteur. Entre les deux conducteurs de cette ligne est prévue une diode de Zener 4 pour la protection du détecteur contre les éventuelles surtensions dans la ligne de liaison 2,3. Sur le conducteur 2 est symbolisé un générateur de courant 5, commandé , susceptible de laisser passer deux valeurs du courant nettement différentes. La plus faible des deux valeurs du courant doit être supérieure à la consommation propre du détecteur, qui est de l'ordre de 0,5 à 1 m A. Le générateur de courant est commandée par deux voies : l'une 8 correspond à la position de la cible 6 par rapport à la limite 7 de la zone de proximité surveillée par le détecteur 1, l'autre 9 correspond à une commande dont le fonctionnement sera décrit plus loin.

Après le générateur de courant 5, une deuxième diode de Zener 10 est prévue entre les deux conducteurs qui vont assurer l'alimentation interne des différents constituants du circuit, cette alimentation n'ayant pas été représentée pour des questions de clarté du dessin.

Le détecteur comprend essentiellement un circuit résonnant LC et un circuit 11, à la fois oscillateur et détecteur de la présence d'oscillations dans le circuit LC. Ce circuit 11 présente trois sorties 12, 13, 14. Entre les sorties 12 et 13, est disposée une résistance 15 dont la valeur est réglable pour définir la position de la limite 7. En parallèle sur la résistance 15 est prévu un circuit 16 ayant pour rôle de commander le fonctionnement forcé de l'oscillateur 11. Entre les sorties 12 et 14 est disposé un circuit 17 susceptible de commander l'arrêt des oscillations. La sortie 12 est reliée à une entrée d'un comparateur 18 dont l'autre entrée est alimentée par une tension de référence 19. La sortie du comparateur 18 est appliquée à l'entrée d'un compteur binaire 20. La sortie Q9 correspondant au bit de rang 9 commande un circuit monostable 21 dont la sortie commande d'une part directement le circuit 16, d'autre part, par l'intermédiaire d'un inverseur 22, le circuit 17, de façon que ces deux circuits soient en service alternativement. La sortie Q11, correspondant au bit de rang 11, est reliée à une porte OU-NON 23 dont la sortie correspond à la deuxième voie de commande 9 du générateur de courant 5. La sortie Q12 , correspondant au bit de rang 12 du compteur 20, est reliée d'une part à la porte 23, d'autre part à un circuit 24 commandant la remise à zéro du compteur 20 après une durée déterminée, et enfin aux circuits 16 et 17. Le circuit 24 a une particularité :si la sortie Q12 revient à zéro avant la fin de ladite durée déterminée, alors la commande de remise à zéro est annulée.

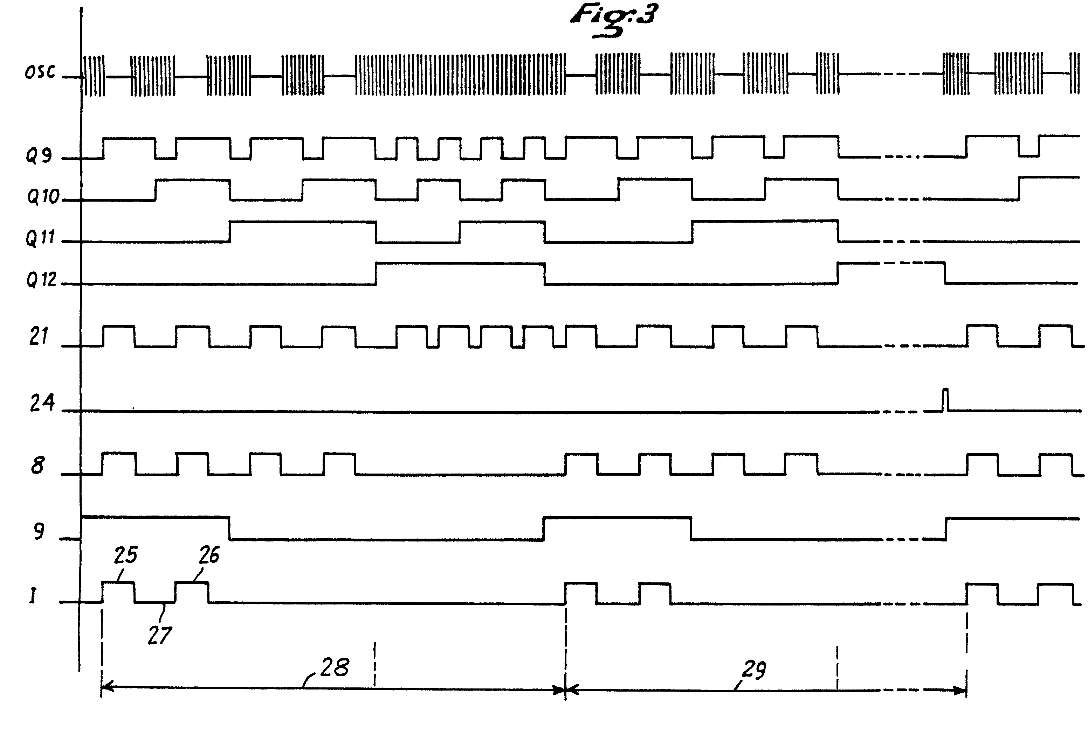

Le fonctionnement du circuit de la figure 1 va maintenant être décrit avec référence au schéma de la figure 3, représentatif des signaux électriques en différents points du circuit. Le détecteur 1 étant du type à courants de Foucault, on constate la présence d'oscillations dans le circuit LC lorsque la cible 6 est en position éloignée, c'est-à-dire au-delà de la limite 7, et l'absence d'oscillations lorsque cible est en position rapprochée, c'est-à-dire en deçà de la limite 7 par rapport au détecteur 1.

Pour assurer le contrôle du bon fonctionnement du capteur, tout en détectant la position de la cible par rapport à la limite de la zone de proximité à surveiller , on procède de la manière suivante : d'une manière cyclique, on force l'oscillateur à osciller quelle que soit la position de la cible, puis on le bloque, toujours quelle que soit la position de la cible, on renouvelle eventuellement cette alternance plusieurs fois,et ensuite on laisse l'oscillateur libre, pour détecter la position de la cible. Pour forcer les oscillations, on n'agit pas directement sur le circuit LC, mais on agit au moyen du circuit 16 pour déplacer nettement la limite de zone 7 vers le détecteur 1 de sorte que, quelle que soit sa position réelle, la cible 6 se trouve au-delà de la nouvelle limite. En pratique, le circuit 16 comporte une résistance faible qui est mise en parallèle sur la résistance 15,ce qui a pour effet de ramener la limite de zone très près du détecteur 1. Le cible étant alors vue par le capteur comme au-delà de la limite 7, l'oscillateur oscille et commande le générateur de courant 5 par la voie 8,de sorte que le courant I sur la ligne 2,3 soit faible. De cette manière, la vérification inclut le circuit oscillant LC, l'oscillateur électronique et le détecteur des oscillations figurés symboliquement par le circuit 11.

Les oscillations présentes à la sortie 12 de l'oscillateur sont appliquées au comparateur 18 qui les transforme en signaux carrés comptés par le compteur 20. On peut remarquer que le compteur 20 est alimenté, non pas par une horloge indépendante, mais par l'oscillateur lui-même .S'il n'y a pas d'oscillations, il ne peut y avoir de comptage. Le détecteur comporte donc un contrôle intrinsèque , ou autocontrôle.

A la mise sous tension du détecteur, le compteur se met à zéro et le circuit monostable 21, en l'absence de commande, impose le fonctionnement du circuit 16 et de l'oscillateur 11. Les oscillations, transformées par le comparateur 18, sont comptées en 20. Après comptage d'un certain nombre d'impulsions, la sortie Q9 passe à l'état 1, et commande le basculement du circuit monostable 21, ce qui provoque le blocage du circuit 16, le fonctionnement du circuit 17 et l'arrêt des oscillations. Le circuit 11 détecte l'absence d'oscillations dans le circuit LC et, en conséquence, commande par la voie 8 le générateur de courant 5 qui passe au courant de forte valeur pendant la durée de l'impulsion du circuit monostable 21. Sur la figure 3, l'impulsion de courant I correspondante est désignée par 25 sur la dernière ligne.

Lorsque le circuit monostable 21 rebascule, il supprime l'arrêt des oscillations par le circuit 17 et commande le fonctionnement de l'oscillateur 11, par l'intermédiaire du circuit 16. Du fait de la présence des oscillations, le circuit 11 commande par la voie 8 le générateur de courant 5 en vue de son retour au courant de valeur faible. Simultanément, le comptage des impulsions recommence, jusqu'à ce que la sortie Q9 repasse à l'état 1. On a ainsi une deuxième impulsion 26 du courant I qui est séparée de la première par un créneau 27.

Le fonctionnement alterné de l'oscillateur 11 continue, avec ses périodes d'oscillation et ses périodes de blocage. Lorsque la sortie Q11 passe à l'état 1, la porte 23 change d'état de sortie et commande, par la voie 9, le générateur de courant 5 pour imposer un courant de faible valeur (ligne 9 sur la figure 3), quelle que soit la commande donnée par la voie 8.

Lorsque la sortie Q11 revient à l'état 0, simultanément la sortie Q12 passe à l'état 1, commande le blocage des deux circuits 16 et 17 et déclenche le circuit 24 pour sa durée prédéterminée. Le circuit oscillateur 11 est alors libre de fonctionner pour détecter la position de la cible 6 par rapport à la limite de zone 7.

Si la cible est éloignée, l'oscillateur 11 oscille librement, et le comptage se poursuit jusqu'à ce que la sortie Q12 revienne à l'état 0 et inhibe le circuit 24. Le processus initial recommence alors. Jusqu'à ce moment, le courant I reste à sa valeur faible. Sur la figure 3, en bas, le segment 28 représente la durée d'un cycle complet de fonctionnement du détecteur lorsque la cible est éloignée. La partie gauche du cycle représente la phase de contrôle du fonctionnement du détecteur et la partie droite du cycle représente la phase de détection de la position de la cible.

Si la cible est rapprochée au moment du passage à l'état 1 de la sortie Q12, l'oscillateur 11 est libre d'osciller mais la présence de la cible bloque les oscillations. Tous se passe alors comme représenté sur la partie droite de la figure 3, sur laquelle le segment 29 représente un cycle complet de fonctionnement du détecteur lorsque la cible est rapprochée. Dans ce cycle 29, la partie gauche correspond à la phase de contrôle du fonctionnement du détecteur, qui est identique à celle du cycle 28, et la partie droite correspond à la phase de détection de la position de la cible. Du fait qu'il n'y a plus d'oscillations, il n'y a plus de comptage. Au bout de la durée déterminée qui le caractérise, le circuit 24 commande la remise à zéro du compteur 20 (ligne 24, figure 3), qui redéclenche le processus initial.

Le signal reçu par le récepteur en bout de la ligne d'alimentation 2-3 se compose donc de deux impulsions de courant 25, 26 séparées entre elles par un créneau 27, deux paires successives de ces impulsions étant séparées par un espace de durée définie en fonction de la position de la cible par rapport à la limite de la zone de proximité surveillée.

Par l'analyse de ce signal, on connait donc à la fois la position de la cible et l'état de fonctionnement du détecteur. En effet, la durée des impulsions de courant 25, 26, est égale à la durée de l'impulsion du circuit monostable 21, et elle doit donc être constante et connue lorsque le fonctionnement du capteur est correct. La durée du créneau 27 qui sépare les deux impulsions d'une paire est donnée par un comptage d'impulsions dont la fréquence est définie par le circuit LC. La largeur du créneau 27 peut être mesurée pour en déduire la fréquence du circuit LC, et vérifier que cette fréquence est bien la fréquence nominale du circuit LC, et donc que le fonctionnement de l'oscillateur est correct.

La fréquence de récurrence des paires d'impulsions permet de définir la position de la cible par rapport à la limite de la zone de proximité : la fréquence de récurrence est plus élevée quand la cible est éloignée que quand elle est proche. La durée qui sépare deux paires d'impulsions est la somme de temps de comptage courts, de temps d'arrêt définis par le circuit monostable 21, et d'un temps de comptage long quand la cible est éloignée, ou de la période du circuit 24 quand la cible est rapprochée. La mesure de la durée qui sépare deux paires d'impulsions permet donc une vérification supplémentaire pour la fréquence du circuit LC, la durée de l'impulsion du circuit monostable 21 et éventuellement pour la durée de la période du circuit 24.

Enfin, si les signaux reçus en bout de ligne ne correspondent pas à l'un des modèles, respectivement pour la cible éloignée et la cible rapprochée, on peut en déduire l'existence d'un défaut de fonctionnement.

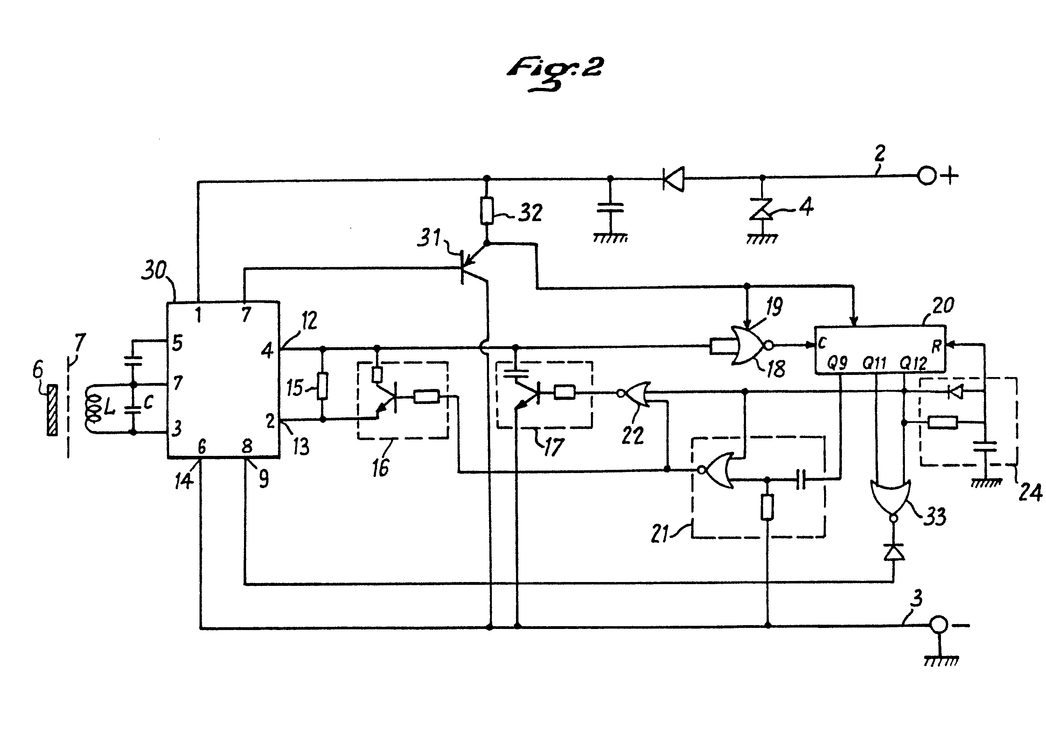

Sur la figure 2 est schématisé un circuit correspondant à un exemple de réalisation pratique du détecteur selon l'invention. Les références de la figure 1 ont été reportées sur la figure 2. La différence apparente entre les deux figures provient du fait que le circuit intégré 30 de la figure 2 assure les fonctions des circuits 11 et 5 de la figure 1. Les bornes de ce circuit, qui est du type TDA 161 de THOMSON, ont été référencées de la manière habituelle. Pour la clarté du dessin, la borne 7 a été représentée à deux emplacements différents. Entre les bornes 5 et 7 est représentée une capacité qui est recommandée pour le bon fonctionnement du circuit 30.

Le transistor 31, en série avec la résistance 32, permet d'assurer l'alimentation du compteur 20 ainsi que la polarisation de référence de la porte 18 qui joue le rôle de comparateur.

Le circuit 16 comprend essentiellement une résistance faible et un transistor pour commander la mise en parallèle de cette résistance sur la résistance 15 et faire ainsi baisser la résistance vue par le circuit 30, ce qui revient à déplacer la limite de zone 7 vers le détecteur.

Le circuit 17 comporte essentiellement une capacité et un transistor , pour assurer la mise à la masse de la sortie 12, en ce qui concerne les signaux alternatifs. Les circuits 21 et 24 sont des circuits à constantes de temps nettement différentes.

Dans un exemple de réalisation d'un détecteur de ce type, on peut avoir approximativement comme valeurs pratiques : une fréquence d'oscillation du circuit LC d'environ 200 kHz, une durée des impulsions de courant de 0,5 à 1 ms, un écart entre deux impulsions de courant d'une même paire de 2 à 2,5 ms, une pause entre deux paires d'impulsions de 5 à 15 ms lorsque la cible est éloignée, et de 20 à 40 ms lorsque la cible est rapprochée , une valeur faible du courant de 1 à 2 mA, une valeur forte du courant de 10 à 15 mA, et une consommation moyenne du détecteur de 3 à 4 mA. Un tel détecteur est particulièrement bien adapté au contrôle de position des organes mobiles dans un avion par exemple, tels que portes ou train d'atterrissage.

Sur la figure 4, on voit le détecteur 1 avec la cible 6 et ses deux fils d'alimentation 2 et 3. Le fil 2 est relié à une source d'alimentation 31 par l'intermédiaire d'une résistance 32, et à l'entrée 33 du récepteur de mesure par l'intermédiaire d'une capacité 34.

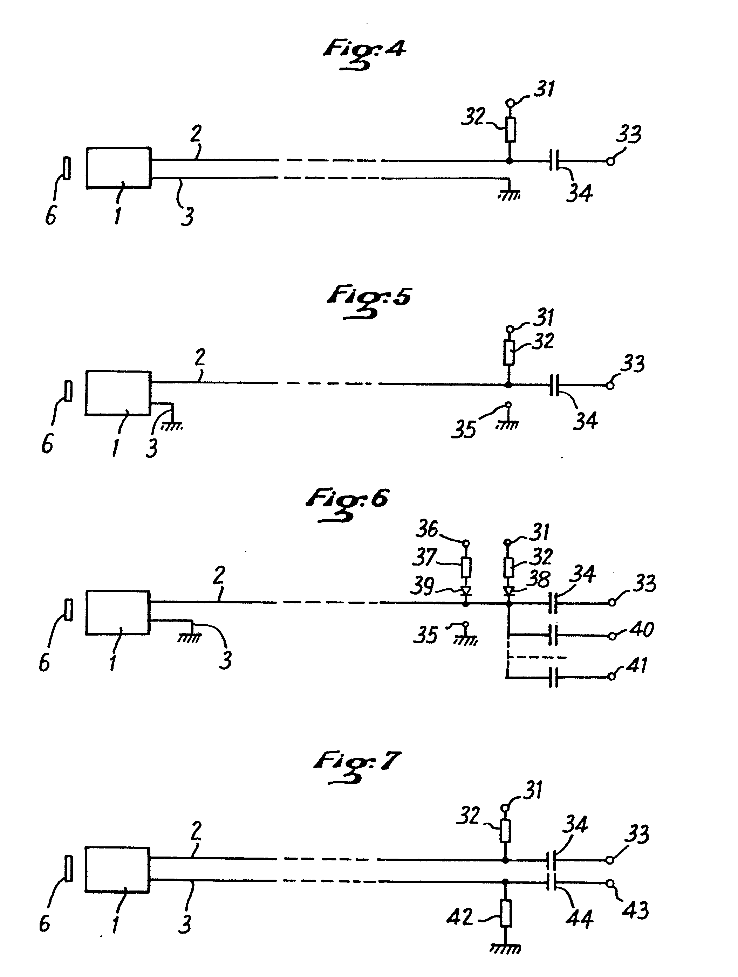

Sur la figure 5, le fil de retour 3 a été supprimé. En sortie du détecteur 1, ce fil est relié à une masse ou à un fil de retour commun à plusieurs détecteurs. La borne 35 , reliée à la masse, symbolise la borne commune du circuit d'alimentation et de réception.

Sur la figure 6, on a représenté une première source d'alimentation 31, avec sa résistance 32 et une diode 38 de protection en série. Une deuxième source d'alimentation 36 est prévue, avec une résistance 37 et une diode de protection 39. Les deux sources d'alimentation peuvent alors fonctionner, sans risque, en parallèle.

Quel que soit le mode de réalisation de l'alimentation, plusieurs récepteurs peuvent être prévus en parallèle comme dans l'exemple de la figure 6, symbolisés par leurs entrées 33, 40, 41.

Sur la figure 7, est représenté un mode de réalisation particulier dans lequel le récepteur a une entrée symétrique. L'entrée du récepteur est constituée par les deux bornes 33 et 43, munies chacune d'une capacité 34 et 44, respectivement. Entre le conducteur de retour

3 et la masse est disposée une résistance 42. De cette manière, la charge de la source d'alimentation 32 est répartie entre les deux résistances 32 et 42.

Grâce à la présence du générateur de courant, le détecteur selon l'invention, peut être alimenté à partir d'une source de tension non stabilisée et variable dans de larges limites. De ce fait, on peut avoir un fil de retour commun à plusieurs détecteurs, voire un retour par la masse, et le détecteur peut être considéré comme relié à son alimentation et à son récepteur par un seul fil.

Le détecteur selon l'invention présente plusieurs avantages et notamment les suivants :

- il n'exige que deux fils dont un fil d'alimentation et de contrôle, et un fil de retour, qui peut d'ailleurs être commun à plusieurs détecteurs;

- l'électronique étant intégrée au détecteur, travaille dans des conditions de détection favorables;

- le circuit électronique est très restreint, ce qui diminue le risque de pannes ;

- il n'y a pas d'horloge indépendante pour générer des impulsions à compter, ce qui assure l'autocontrôle du détecteur ;

- grâce à cet autocontrôle, on a en permanence connaissance du bon état de fonctionnement du détecteur;

- les signaux transmis par le détecteur sont simples et bien définis, ils consistent en une variation prédéterminée de l'intensité du courant ;

- ces signaux sont constitués par des paires d'impulsions dont la fréquence de récurrence dépend de la position de la cible par rapport à la limite de la zone de proximité ;

- la présence des paires d'impulsions, la largeur de chaque impulsion et la largeur du créneau séparant les deux impulsions d'une paire, sont autant d'éléments mesurables pour apprécier le bon fonctionnement du détecteur.

Le détecteur selon l'invention est à électronique intégrée, il s'autocontrôle en permanence, et il transmet à un ou plusieurs récepteurs, l'information relative à son fonctionnement simultanément avec l'information relative à la position de la cible en deux états : au-delà ou en deça de la limite de la zone de proximité surveillée par le détecteur.

Revendications

1. Détecteur de proximité autocontrôlé , à électronique intégrée, détectant la position d'une cible par rapport à une limite de zone de proximité grâce au phénomène des pertes par courants de Foucault, comportant un circuit oscillant LC et un oscillateur, caractérisé en ce qu'un compteur (20) des oscillations définit un cycle de fonctionnement du détecteur , avec une première période de contrôle du fonctionnement du détecteur (1) et une deuxième période de détermination de la position de la cible (6).

2. Détecteur selon la revendication 1, caractérisé en ce qu'il comporte : un circuit (16) pour forcer le fonctionnement de l'oscillateur (11), un circuit (17) pour commander l'arrêt des oscillations, un circuit monostable (21) pour commander alternativement , l'un ou l'autre des circuits précédents (16, 17), et un compteur (20) comptant les oscillations qu'il reçoit de l'oscillateur (11), et commandant le circuit monostable (21).

3. Détecteur selon la revendication 2, caractérisé en ce qu'il comporte un circuit (24) de remise à zéro du compteur (20) après une durée déterminée, de façon à mettre fin au cycle de fonctionnement du détecteur (1) en l'absence d'oscillations, c'est-à-dire lorsque la cible est rapprochée.

4. Détecteur selon la revendication 2, caractérisé en ce que dans la première période du cycle de fonctionnement du détecteur, les signaux permettant le contrôle du fonctionnement correct du détecteur sont constitués par deux impulsions de courant (25, 26) séparées par un créneau (27).

5. Détecteur selon la revendication 4, caractérisé en ce que chacune desdites impulsions de courant (25, 26) a une durée égale à celle de l'impulsion du circuit monostable (21).

6. Détecteur selon la revendication 4, caractérisé en ce que la durée dudit créneau (27) est fonction de la fréquence des oscillations.

7. Détecteur selon la revendication 1, caractérisé en ce que la durée de la deuxième période du cycle de fonctionnement du détecteur est caractéristique de la position de la cible par rapport à la limite de la zone de proximité.

8. Détecteur selon la revendication 7, caractérisé en ce que lorsque la cible est éloignée, la durée de ladite deuxième période du cycle est définie par comptage des oscillations.

9. Détecteur selon l'ensemble des revendications 3 et 7, caractérisé en ce que lorsque la cible est rapprochée, la durée de ladite deuxième période du cycle est définie par la période du circuit de remise à zéro (24).

10. Détecteur selon la revendication 1, caractérisé en ce qu'il comporte un générateur de courant (5), susceptible d'être commandé par deux voies, disposé sur le fil (2) de sa ligne d'alimentation relié à une source de tension (31) non stabilisée et susceptible de varier dans de larges limites.

11. Détecteur selon la revendication 10, caractérisé en ce que le fil (3) de retour est communn à plusieurs détecteurs.

12. Détecteur selon la revendication 10, caractérisé en ce que le fil de retour (3) est mis à la masse à la sortie du détecteur (1) de sorte que le détecteur est à un seul fil (2).

Fig.1

*Fig.2*

Fig.3

0244311

## Fig.4

## Fig.5

## Fig.6

## Fig.7

**0244311**

Office européen
des brevets

**RAPPORT DE RECHERCHE EUROPEENNE**

Numéro de la demande

EP 87 40 0948

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| A | EP-A-0 156 696 (PETERCEM S.A.)<br>* En entier *<br><br>--- | 1,2 | G 01 B 7/02<br>G 01 B 7/14<br>H 03 K 17/95 |
| A | EP-A-0 132 850 (H. KAMMERER)<br><br>* En entier *<br><br>--- | 1,2,4,5 | |
| A | DE-A-3 220 111 (P. LÜHR)<br><br>* Figure 3; colonne 3, ligne 37 - colonne 4, ligne 62 *<br><br>--- | 1,2,4,6 | |
| A | FR-A-2 568 380 (PETERCEM S.A.)<br><br>* En entier *<br><br>--- | 1-3,10-12 | |
| A | FR-A-2 213 533 (WAGNER ELECTRIC CORP.)<br>* Page 1, ligne 15 - page 4, ligne 35; revendication 1 *<br><br>----- | 1 | **DOMAINES TECHNIQUES RECHERCHES (Int Cl 4)**<br><br>G 01 B 7/00<br>G 01 D 5/00<br>H 03 K 17/00 |

Le présent rapport de recherche a été établi pour toutes les revendications

| Lieu de la recherche<br>LA HAYE | Date d'achèvement de la recherche<br>22-07-1987 | Examinateur<br>BROCK T.J. |
|---|---|---|